# EUROPEAN PATENT APPLICATION

(11) **EP 2 317 831 A1**
(43) Date of publication of application: **04.05.2011**
(21) Application number: 09174682.6
(22) Date of filing: 30.10.2009
(51) Int. Cl.: H05K 3/10

(54) **Method and apparatus for curing a substance comprising a metal complex**

(71) Applicant: Nederlandse Organisatie voor Toegepast -Natuurwetenschappelijk Onderzoek TNO, 2628 VK Delft (NL)
(72) Inventor: Andriessen, Hieronymus Antonius Josephus Maria, 2340 Beerse (BE); Van Lammeren, Tim Johannes, 5654 BN Eindhoven (NL); Rucareanu, Simona Magdalena, 5611 VZ Eindhoven (NL)
(74) Representative: Hatzmann, Martin

(57) **Abstract**

The present invention provides an apparatus (1) for curing a substance (2a, 2b, 2c) at an organic substrate (2), the substance comprising a metal complex, the apparatus comprising a first radiation facility (3) for preparing the substance by exposure to UV-radiation and second radiation facility (4) for subsequently pulse-wise exposing the prepared substance with photon radiation having a wavelength in the visible range.

The present invention further provides a method of curing a substance at an organic substrate, the substance comprising a metal complex, the method comprising the steps of
- preparing the substance by exposure to UV radiation,
- radiating the prepared substance with pulsed photon radiation substantially having a wavelength in the visible range.

## Description

### BACKGROUND OF THE INVENTION

### Field of the Invention

The present invention relates to a method for curing a substance comprising a metal complex.

The present invention further relates to a method for curing a substance comprising a metal complex.

### Related Art

It is known to apply conductors by printing or otherwise applying a conductive substance and curing the applied substance. Alternatively the substance may be converted from a non-conductive to a conductive state after application.

Printed conductive inks deposited on flexible substrates like PEN and PET are often difficult to cure/sinter because of their relatively high curing temperatures, which are often not compatible with polymeric substrates. Some of the recent developed so-called low temperature sinter-able inks require only 120 - 150°C. These inks usually consist of metal (silver) particles, metal (silver) complexes or a combination thereof. Although these sintering temperatures are more compatible with plastic substrates, the sintering times (> 30 minutes) are still not compatible with future roll to roll (R2R) production techniques. A recently developed very attractive alternative is based on exposure of the applied substance by a pulsed photon radiation source, e.g. a Xe-flash light. As the radiation that is not absorbed by the printed substance is substantially transmitted by the substrate, the heat-load by direct absorption of the substance is relatively low.

This alternative is compatible with R2R production constraints as the sintering can be realized within a few seconds. Furthermore, the pulse-wise application of radiation allows an intensive heating of the substance, while the time for conductance of the heat from the printed substance to the substrate is relatively short, so that the heat load of the substrate by conduction is also kept modest.

WO2006071419 describes a method in which nanomaterial compositions are exposed to pulsed emissions to react, activate, combine, or sinter the nanomaterial composition. The nano-material compositions can alternatively be utilized at ambient temperature or under other means to cause such reaction, activation, combination, or sintering to occur.

Compositions based on metal-complexes are advantageous in that they can be applied by printing in a relatively high concentration of metal as compared to substances based on nano-materials. However, for substances based on metal-complexes, e.g. silver-complexes this approach seems to result in longer sintering times compared to metal nano-particles. Even worse, if the printing and pre-drying of the metal-complex ink is done only at room temperature, this approach seems even to be impossible, no matter how long the printed material is exposed to illumination, certainly for some feature sizes.

### SUMMARY OF THE INVENTION

It is an object of the present invention to provide an improved method and apparatus.

According to a first aspect of the invention an apparatus is provided for curing a substance at an organic substrate, the substance comprising a metal complex, the apparatus comprising a first radiation facility for preparing the substance by exposure to UV-radiation and second facility for subsequently pulse-wise exposing the prepared substance with photon radiation substantially having a wavelength in the visible range.

Radiating the substance with pulsed photon radiation requires a rather powerful radiation source. It has been found by the inventor that the preparation of the substance by exposure to UV-radiation results in a significant reduction in the required time of exposure to the pulsed photon radiation source. Therewith a significant reduction in overall power consumption is achieved, even when taking into account the power consumed by the UV-radiation source.

It is believed that the radiation of the substance with an UV-radiation source results in a forming of metallic seeds and that these metallic seeds provide for an increased absorbance during the subsequent radiation with the pulsed photon radiation source.

It is noted that WO0035259 describes a method for producing fine metallic conductor structures on an electrically non-conductive substrate. According to said method an electrically non-conductive heavy metal complex is applied to the substrate and the substrate is selectively subjected to ultraviolet laser radiation in the area of the conductor structures to be produced. As a result heavy metal seeds are released. In a subsequent step the area is metalized by a chemical reduction process. In this process the main part of the conductive lines is formed by said metallization. The deposition from the metal-complex merely serves as an electrode or catalyst for said reduction process.

The pulse-wise operation of the radiation source having a spectrum in the visible range provides for an intensive heating of the substance while conduction of heat to the substrate is modest. Substantially no radiation in the wavelength range of 400 to 700 nm is absorbed by the substrate that carries the substance. This makes it possible to radiate the substance via the substrate. Furthermore, to improve efficiency, the radiation transmitted through the substrate can be returned by reflection towards the substance.

Normally a printing temperature clearly above room temperature is useful for the subsequent sintering process of metal complex comprising substances. However, in the method according to the first aspect of the invention is has surprisingly been found that a relatively low printing temperature results in an even higher reduction in the required time of exposure to the pulsed photon radiation. A suitable temperature range is for example 10 - 30 deg.

In particular the printing temperature may be room-temperature, i.e. in the range of 15-25 °C, e.g. 20 °C, so that separate heating or cooling devices to control the temperature of the printing process are superfluous.

In an embodiment the metal-complex is a silver complex, a copper complex, a nickel-complex, an aluminum-complex or any mixture thereof. Silver, cupper, aluminum and nickel are excellent conductors.

More than 50% of the power of the radiation of the UV-source has a wavelength in a range of less than 400 nm. In an embodiment at least 2/3 of the radiation of the UV-source is comprised in a range less than 400 nm. Various metal complexes, like silver complex solutions have a relatively high absorption in said wavelength range.

Photon radiation substantially having a wavelength in the visible range implies that more than 50% of the radiated power should be in the wavelength range of 400 nm to 700 nm. In practice this implies that at least 2/3 of the power of the radiation is in this wavelength range. Radiation having a wavelength in this wavelength range is substantially transmitted by substrates that are most used for this purpose. Accordingly the substance deposited at the substrate and prepared by UV-radiation may be further radiated by the second radiation facility without significantly heating the substrate by absorption of radiation. This has the advantage that the substance to be cured may also be irradiated by the second radiation facility via the substrate.

In an embodiment the second radiation facility is operated with a pulse frequency in the range of 10 to 500 pulses per second. If the pulse frequency is substantially less than 10 pulses per second, e.g. less than 5 pulses per second, it becomes difficult to process the substrate at a sufficiently high linear speed in a roll to roll process at energy densities where the substrate is not affected. If the pulse frequency is substantially higher than 500 pulses per second, e.g. more than 1000 pulses per second the energy per pulse may become too low to result in a sufficient sintering of the metal seeds unless highly complicated high energy and high frequency power generators are used. In a practical embodiment the pulse frequency is for example in a range of 10 to 50 pulses per second, e.g. about 20 pulses per second.

According to a second aspect of the invention there is provided a method of curing a substance at an organic substrate, the substance comprising a metal complex, the method comprising the steps of
- preparing the substance by exposure to UV radiation,
- radiating the prepared substance with pulsed photon radiation substantially having a wavelength in the visible range.

### BRIEF DESCRIPTION OF THE DRAWINGS

These and other aspects are described in more detail with reference to the drawing. Therein,
FIG. 1 shows a side-view of an apparatus according to an embodiment of the first aspect of the invention,
FIG. 1A shows a portion of a substrate according to view A in FIG. 1,
FIG. 1B shows a cross-section of the substrate according to B-B in FIG. 1A,
FIG. 2 shows a perspective view of a part of the apparatus of FIG. 1,
FIG. 3 shows a cross-section of said part according to the same view as that of FIG. 1,
FIG. 4 shows a cross-section according to IV-IV in FIG. 3,
FIG. 5 shows a corresponding part in another embodiment of the apparatus,
FIG. 6 shows first measurement results,
FIG. 7 shows second measurement results,
FIG. 8 shows third measurement results,
FIG. 9 schematically shows a measuring arrangement.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

In the drawings, the size and relative sizes of layers and regions may be exaggerated for clarity.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. All publications, patent applications, patents, and other references mentioned herein are incorporated by reference in their entirety. In case of conflict, the present specification, including definitions, will control. In addition, the materials, methods, and examples are illustrative only and not intended to be limiting.

### Like elements have like reference numerals.

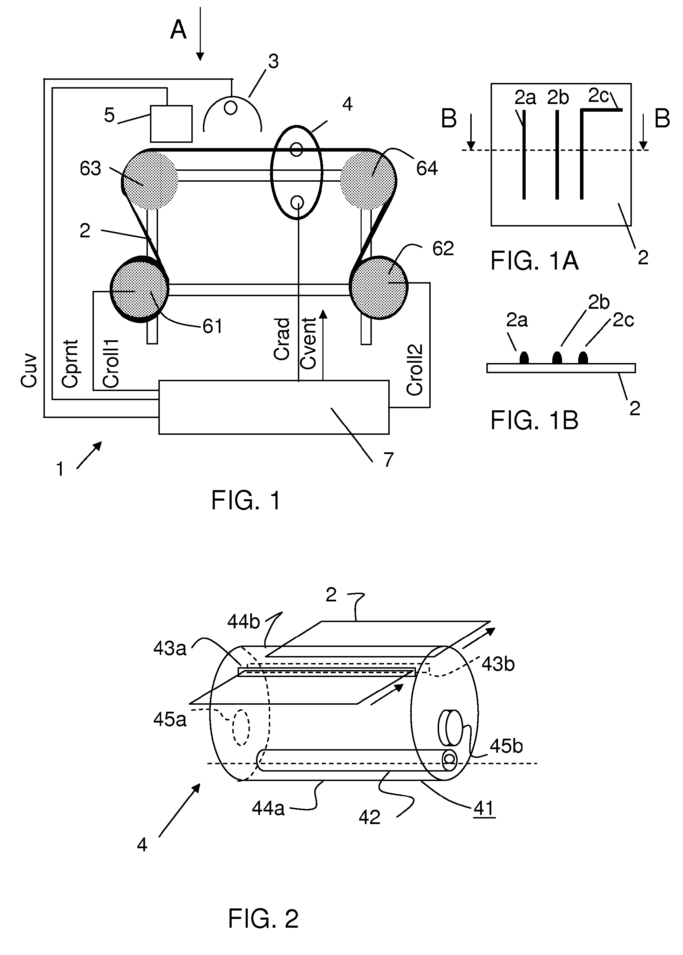

Figure 1 shows an embodiment of an apparatus 1 according to a first aspect of the invention.

The apparatus has a printing arrangement 5 for printing a substance at the substrate 2. The substance comprises a metal complex, e.g. in an organic or water based solvent. Such substances are for example silver complex inks comprising a mixture of solvents and silver amides, for example inks produced by InkTec. The silver amides decompose at a certain temperature between 130-150°C into silver atoms, volatile amines and carbon dioxide. Once the solvents and the amines are evaporated, the silver atoms remain on the substrate. Other metal complexes based for example on copper, nickel, zinc, aluminum, cobalt, palladium, gold, vanadium, and bismuth instead of silver may be used alternatively or in combination. Examples of copper complex based substances are shown in the following table.

**Table 1: Examples of substances comprising a Cu-complex component**

| |
|---|
| Cu(neodecanoate)₂ (6-12% Cu; from Strem Chemicals) |
| Cu(acetate)₂.H₂O (from Sigma Aldrich) |
| complex with ethanolamine is soluble in water (concentration N/A) |
| Cu(formate) ₂.4 H₂O (from Gelest) |

Figure 1A shows a top-view of the substrate 2 according to A in FIG. 1. FIG. 1B shows a cross-section of the substrate 2 according to B-B in FIG. 1A. In FIGs 1A and 1B it can be seen that in the embodiment shown the substance is printed in the form of a plurality of lines 2a, 2b, 2c.

The apparatus 1 of FIG. 1 has a first radiation facility 3 for preparing the substance 2 by exposure to UV-radiation and second radiation facility 4 for subsequently pulse-wise exposing the prepared substance 2 with photon radiation having a wavelength in the visible range.

The apparatus is further provided with a transport system for transporting the substrate 2 from the printing arrangement 5, to the first radiation facility 3 and subsequently to the second radiation facility 4. In the embodiment the transport system comprises a supply roll 61 for supplying the substrate 2 and a storage roll 62 for storing the processed substrate foil 2. In addition the transport system comprises guidance rolls 63, 64. In an embodiment the transport system transports the substrate in a continuous manner. In another embodiment the transport system transports the substrate stepwise.

The apparatus 1 furthermore comprises a controller 7 that controls the first radiation facility 3 by a signal Cuv and the second radiation facility 4 by a signal Crad. The controller 7 allows changing settings like lamp intensity, pulse duration, interval time, and the number of pulses, to find the optimal settings for curing. The controller 7 further controls an actuator (not shown) for the supply roll 61 by a signal Croll1 and an actuator (not shown) for the storage roll 62 by a signal Croll2. The controller 7 further controls the printing arrangement 5 with a signal Cprint and also controls a ventilation system by a signal Cvent.

In the embodiment shown, the printing arrangement 5 is a piezoelectric Dimatix DMP 2800 (Dimatix-Fujifilm Inc., USA) inkjet printer, equipped with a 10 pL cartridge (DMC-11610). The print head thereof contains 16 parallel squared nozzles with a diameter of 30 µm. Alternatively another inkjet printer may be used as the printing arrangement. In again another embodiment another type of printing device is used, e.g. a (rotary)screen printer, a (roto)gravure printer or flexo-(graphic) printer.

In again another embodiment the metal complex solution is applied as a homogeneous layer, e.g. by spin-coating or spraying and the homogeneous layer so obtained is irradiated according to a desired pattern, so that only the properly irradiated portions become conducting. In that embodiment a printing arrangement is superfluous.

In the embodiment shown the first radiation facility 3 is a Philips UV-C source having the following specification for the radiation intensity at the surface of the substrate.

**Table 2: Specification of UV-source 1**

| Wave length (nm) | Intensity (µW/cm²) |
|---|---|
| 250 - 260 | 5306 |
| 360 - 370 | 129 |
| 310 - 390 (UV A) | 281 |
| 250 - 585 | 6239 |

| | |
|---|---|
| This UV source is denoted in the sequel also as UV-source 1. | |

In another embodiment the first radiation facility 3 is a radiation source of type UCL 300 of Electro-lite having a lamp ECL-400 with an output power of 100 mW/cm2 and a spectrum having a peak at 365 nm. This UV-source is denoted in the sequel also as UV-source 2.

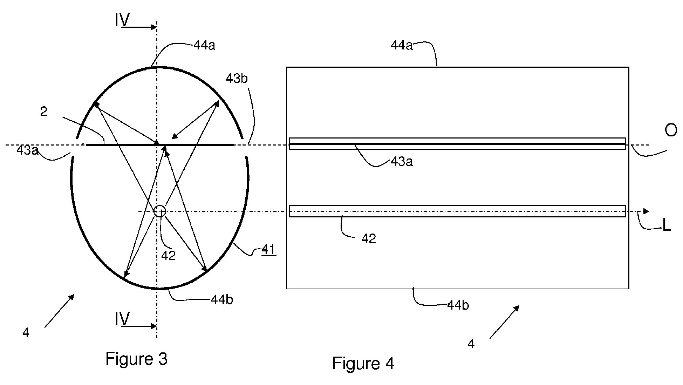

FIG. 2 shows in a perspective view the second radiation facility 4 in more detail. The second radiation facility 4 comprises a tube 41 in the form of an elliptic cylinder having a reflective inner surface. A tubular photon radiation source 42 is arranged concentric with a first focal line of the elliptic cylinder 41. The tube is provided with a first and a second slit-shaped opening 43a, 43b that extend opposite to each other between a first and the second reflecting surface 44a, 44b in the direction of the length axis. The imaginary plane through the first and the second slit-shaped opening 43a, 43b is denoted herein as object-plane O (see fig. 3, 4). During operation of the device the guiding rolls 63, 64 shown in FIG. 1 function as a guidance facility that guide the substrate 2 via first slit-shaped opening 43a through a second focal line of the elliptical cylinder to the second slit-shaped opening 43b.

The tube 41 is provided with a ventilation system 45a, 45b.
FIG. 3 and FIG. 4 respectively show a cross-section transverse through a length axis L and a cross-section along the length axis L of the second radiation facility 4. The second cross-section is indicated as IV-IV in FIG. 3.

In the embodiment shown the tubular photon radiation source 42 is a Xelamp of type Philips XOP-15 (length 39.5 cm, diameter about 1 cm) and operating at a power of 1000 W and a frequency of 10 flashes per second with a duration of 10 ms. The lamp was operated at 75% of its maximum power. Taking into account an efficiency of 65% of the lamp the power per pulse was estimated at 49 J. In the embodiment shown the radiation of lamp is concentrated in a region having a length of 39,5 cm and a width of 1 cm. The energy losses by imperfect reflection are estimated at 2%. As the lamp radiates most of its power, in this case more than 2/3, in the wavelength range of 400 to 700 nm the absorption in the substrate is negligible. Therewith the energy-density at the surface of the substrate is approximately 1.2 J/cm² per flash.

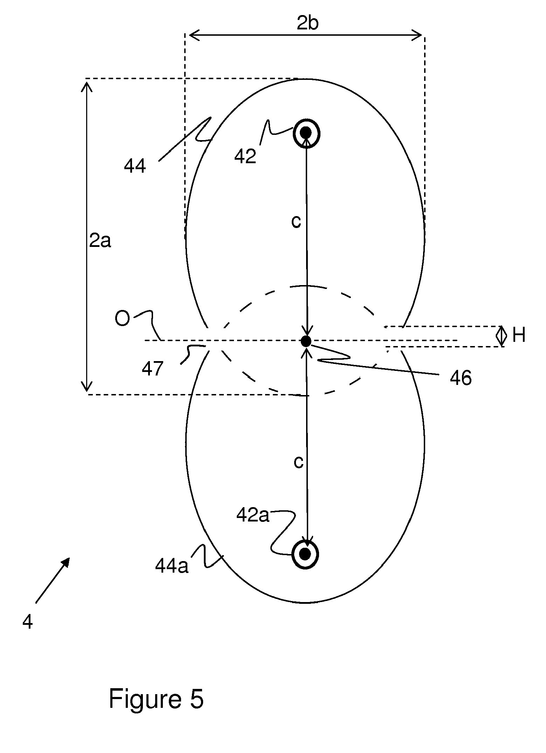

FIG. 5 shows a cross-section of the second radiation facility 4 in an alternative embodiment of the apparatus according to the first aspect of the invention. The second radiation facility 4 has a pair of concave reflective surfaces 44, 44a that are both formed by a section of a respective ellipsoidal cylinder that is coated at its inner side with aluminum foil having a reflectivity of 98%. The section is formed by truncation along the length axis of the cylinder. The truncated portion of the cylinder is indicated by the dotted lines. The concave reflective surfaces 44, 44a each have an own focal line in which a respective tubular photon radiator 42, 42a is arranged. The concave reflective surfaces 44, 44a additionally have a shared focal line 46. A gap 47, in this specific set-up having a height H of 10 mm, is present between the truncated elliptical cylinders 44, 44a. The gap 47 allows the substrate (not shown) to pass through the object-plane O through the shared focal line 46. In this specific set-up the ellipses in untruncated form would have a large axis **2a** of 140mm and a short axis **2b** of 114.8 mm. Accordingly the distance **c** between their first and second focal lines is 80 mm. The second focal lines substantially coincide, in that their distance is less than one fifth (32 mm) the distance between the first focal lines. In particular the distance is less than one tenth (16 mm) the distance between the focal lines. In this case the second focal lines coincide with a tolerance of 1 mm.

The tubular photon radiators 42, 42a are Xenon lamps of type Philips XOP-15 (1000 W, length 39.5 cm) with a diameter of about 1 cm. Dependent on the dimensions of the foil that is to be processed also a tubular radiator of a different length may be used e.g. a Xenon lamp of type Philips XOP-25 (1000 W, length 54.0 cm), also with a diameter of about 1 cm. Also flash lamps having another gas filling may be used, e.g. Kr-lamps or Xe/Kr-lamps. It is merely relevant that the radiation source is capable of providing a high energy dose in a pulse wise operation. If desired different radiation sources may be used for the tubular radiators 42, 42a.

In order to verify the effect of the present invention, various experiments were carried out. Therein conducting lines at a polymer substrate were prepared from an ink comprising a metal complex solution, in particular a silver complex ink, in this case the silver complex ink of type TEC-IJ-040, commercially available from InkTec. The resistance was measured during the execution of the method. The results were compared with those of a method not according to the invention in which the step of treatment with pulsed photon radiation in the visible range was not preceded by a UV-treatment.

The lines of ink to be rendered conductive were printed on a PEN (Polyethylene Naphthalate) foil produced by DuPont Teijin with a thickness of 125 µm. The sides of the foil have a mutually different smoothness. The lines were printed on the smoothest side of the PEN.

The lines of the ink to be rendered conductive were printed using the above-mentioned Dimatix DMP 2800 inkjet printer The substance was printed at a voltage of 28 V, using a frequency of 10 kHz and a customized wave form. The printing height was set to 500 µm, while using a dot spacing of 20 µm. The printed lines had a width of 500 µm.

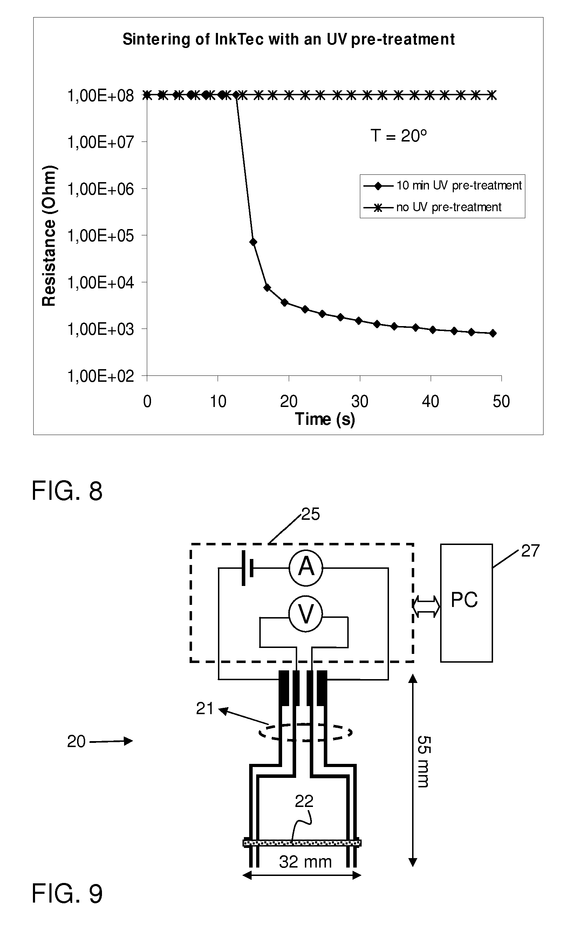

A measuring probe 20 as shown in FIG. 9 was designed, that allowed measuring a resistance of the ink line 21 with a four point resistance measurement. Consequently the resistance of the wires and contact points could be neglected. A Keithley 2400 source meter 25 was connected to a PC 27 and used both as a current source and a voltmeter. This allowed data to be acquired in real time and to be subsequently imported into an Excel template for further analysis. A Memmert Model 400 oven was used to dry and sinter the measuring probe. The printed measurement probes 21 were sintered in the oven at a temperature of 135°C for 30 minutes. Wet ink lines 22 with a width of 500 µm and a length of 25 mm were then printed on the contact points.

### Experiment 1

In a first experiment first samples were prepared by printing with a plate temperature of the inkjet printer set on 60°. One of the first printed samples was irradiated by the above-mentioned UV-light-source of type UV-source 1 for a period of 5 minutes. A second one of the printed samples was irradiated by the above-mentioned UV-light-source of type UV-source 1 for a period of 10 minutes. For comparison a third one of the printed samples was not irradiated by the UV-source. Subsequently each of the three samples was photonically sintered in second radiation facility as described with reference to FIG. 2-4.

The following table shows again the characteristics of the UV-source type 1 and the applied radiation dose at the surface of the samples after a radiation time of 5 minutes and 10 minutes.

**Table 3: Radiation dose applied by UV-source type 1.**

| Wave length (nm) | Intensity (µW/cm²) | Dose 5min (J/cm²) | Dose 10min (J/cm²) |
|---|---|---|---|
| 250 - 260 | 5306 | 1.59 | 3.18 |
| 360 - 370 | 129 | 0.038 | 0.076 |
| 310 - 390 (UV A) | 281 | 0.084 | 0.168 |
| 250 - 585 | 6239 | 1.87 | 3.74 |

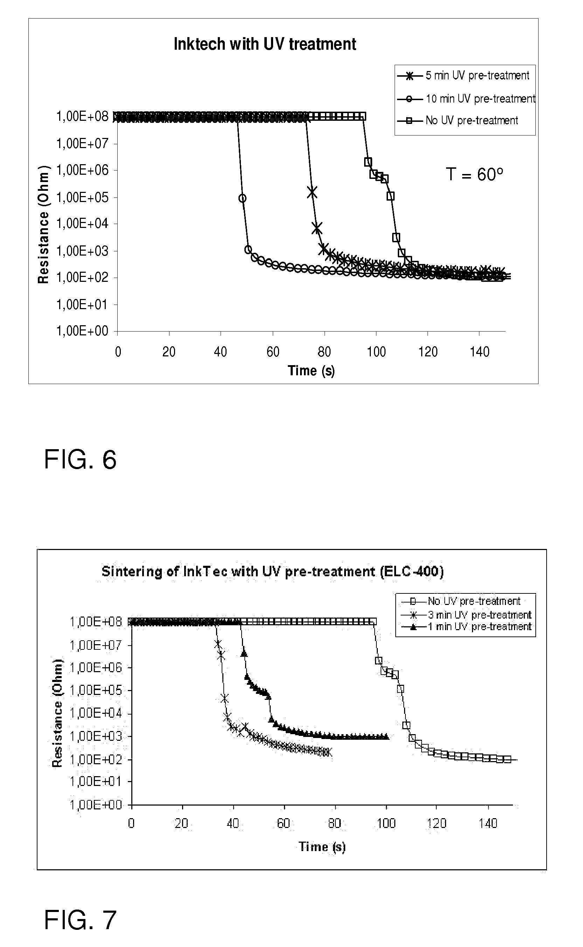

FIG 6. shows the results of the first experiment. The results shown are the resistance in Ω measured for each of the samples as a function of the time in s of radiation with the pulsed radiation source 4. In each case a significant reduction in resistance can be observed from about 10⁸ Ω to about 100 Ω. However, in the case that a UV-treatment is applied, the reduction in resistance is significantly accelerated. In case of a pretreatment having a duration of 5 min the reduction in resistance already starts after 72 s, while in the absence of a UV-pretreatment the reduction starts only after 94 seconds, implying an acceleration with 22 s. In case of a pretreatment having a duration of 10 min the reduction in resistance already starts after 45 s, implying an acceleration with 49 s, which is a reduction with more than 50%.

The following table summarizes the results.

**Table 4: Reduction in sintering time achieved with printing at 60 °C and pretreatment by radiation with UV-source 1.**

| | | **NO** | | |
|---|---|---|---|---|
| | | **UV** | **UV-source 1** | |
| | | | **Dose 5 min** | **Dose 10 min** |
| | **Intensity (µW/cm²)** | | **(1.6 J/cm²)** | **(3.2 J/cm²)** |
| **Time (s)** | | 94 | 72 | 45 |
| **Acceleration (s)** | | | 22 | 45 |
| **Flash Dose (J/cm2)** | | 1128 | 864 | 540 |
| **Total Dose (J/cm2)** | | 1128 | 866 | 453 |
| **Reduction (J/cm2)** | | | 262 | 585 |

In this table, the row indicated by Time (s) shows the point in time at which the treatment with the Flash radiation source was followed by a reduction in resistance of the printed lines. The row "Acceleration (s)" shows the acceleration achieved in the process of radiation with the Flash radiation source.

The row indicated by "Flash dose" shows the radiation dose in J/cm² applied by the Flash radiation source from the start of radiation until the point in time that the resistance started to reduce.

The row "Total Dose" indicates the sum of the Flash Dose and the dose applied by the UV-radiation source.

The row "Reduction" shows the reduction in the total dose by UV-pretreatment for 5 min and for 10 min respectively.

It can be seen that the UV-treatment results in a significant reduction of the required total radiation dose. This is favorable in that it allows a significant reduction in the thermal load of the substrate at which the lines are printed and a significant reduction in the energy consumption involved in the manufacturing process as well.

### Experiment 2

FIG. 7 shows results of an experiment with the UV-radiation source of type UV-source 2. As in the previous experiment the ink-lines were printed with a setting of the plate temperature at 60°C. As shown in FIG. 7, a first sample was pre-treated with this UV-radiation source for 1 min and a second sample was pre-treated therewith for 3 minutes. For comparison FIG. 7 also shows again the results obtained with the sample that was not pre-treated. Now the time required for starting the sintering process, indicated by the onset of a resistance reduction is even further shortened. For the sample that was pre-radiated by 1 min with UV-source 2, the reduction in resistance starts after 42 s, i.e. an acceleration of 52 s as compared with the reference sample. The sample that was pre-radiated by 3 min with this UV-source showed a start in the reduction in resistance after 33 s, i.e. an acceleration of 61 s as compared with the reference sample.

The results are summarized in the following table.

**Table 5: Reduction in sintering time achieved with printing at 60 °C and pretreatment by radiation with UV-source 2.**

| | **NO UV** | **UV source 2** | |
|---|---|---|---|
| | | **Dose 1 min** **(6 J/cm²)** | **Dose 3 min** **(18 J/cm²)** |
| **Time (s)** | 94 | 42 | 33 |
| **Acceleration (s)** | | 52 | 61 |
| **Flash Dose (J/cm2)** | 1128 | 504 | 396 |
| **Total Dose (J/cm2)** | 1128 | 510 | 414 |
| **Reduction (J/cm2)** | | 618 | 714 |

As is clear, in this case an even higher reduction in the total radiation dose is achieved.

### Experiment 3

Even more surprising are the results in a further experiment wherein the metal complex containing substance was printed at room temperature (20°). As shown in FIG. 8, in this case the substance not pretreated by UV-radiation did not experience any visible reduction in resistance during a radiation time of 50 s with a pulsed photon radiation source. The substance that was pre-treated with the UV-radiation source of type 1 however, did show a rapid decrease in resistance already after 12 s of radiation with the pulsed photon radiation source.

The results are summarized in the following table:

For comparison the table also repeats the results obtained when printing the metal complex containing substance at 60 deg.

**Table 6: Reduction in sintering time achieved with printing at 20 °C and pretreatment by radiation with UV-source 2 (For comparison including the results for 60 °C).**

| | **NO UV** | **UV Source 1** | |
|---|---|---|---|
| | | **Dose 10 min (3.2J/cm²)** | |
| | | **printed at** **20 deg** | **printed at** **60 deg** |
| **Time (s)** | >50 | 12 | 33 |
| **Acceleration (s)** | | >38 s | 61 |
| **Flash Dose (J/cm2)** | >600 | 144 | 396 |
| **Total Dose (J/cm2)** | >600 | 147.2 | 399,2 |
| **Reduction (J/cm2)** | | >452,8 | >200,8 |

The experiments confirm that there is a clear synergy between the application of pulsed radiation and the pretreatment with UV-radiation as subsequent steps according to the present invention.

Also printing the metal complex containing substance at room temperature clearly results in an additional reduction in sintering time, provided that the sample is pretreated by UV-radiation before sintering with the pulsed radiation source. A possible explanation for this phenomenon is that printing the metal complex containing substance at a relative high temperature (e.g. 60 °C) results in an initial structure. It is believed that this reduces the mobility of the metal component, and therewith the effect of the pretreatment with UV-radiation. This is not the case when the substance is printed at room temperature.

While the invention has been illustrated and described in detail in the drawings and foregoing description, such illustration and description are to be considered illustrative and exemplary and not restrictive; the invention is not limited to the disclosed embodiments.

Other variations to the disclosed embodiments can be understood and effected by those skilled in the art in practicing the claimed invention, from a study of the drawings, the disclosure and the appended claims. In the claims the word "comprising" does not exclude other elements or steps, and the indefinite article "a" or "an" does not exclude a plurality. A single processor or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. Apparatus (1) for curing a substance (2a, 2b, 2c) at an organic substrate (2), the substance comprising a metal complex, the apparatus comprising a first radiation facility (3) for preparing the substance by exposure to UV-radiation and a second radiation facility (4) for subsequently pulse-wise exposing the prepared substance with photon radiation having a wavelength in the visible range.

2. Apparatus according to claim 1, further comprising a printing arrangement (5) for printing the substance at the substrate.

3. Apparatus according to claim 2, wherein the printing arrangement (5) is arranged to apply the substance at a temperature in a range between 10 and 30 °C.

4. Apparatus according to claim 3, wherein the printing arrangement (5) is arranged to apply the substance at a temperature in the range between 15 and 25 °C.

5. Apparatus according to claim 1, wherein at least 50% of the radiation of the first radiation facility (3) is comprised in a range less than 300 nm.

6. Apparatus according to claim 1, wherein the second radiation facility (4) is operated with a pulse frequency in the range of 5 to 1000 pulses per second.

7. Apparatus according to claim 6, wherein the second radiation facility (4) has an operational mode with a duty cycle in the range of 0.5 to 10%.

8. Method of curing a substance at an organic substrate, the substance comprising a metal complex, the method comprising the steps of
- preparing the substance by exposure to UV radiation,
- radiating the prepared substance with pulsed photon radiation substantially having a wavelength in the visible range.

9. Method according to claim 8, wherein the metal complex is a silver-complex or a copper-complex.
